# EUROPÄISCHE PATENTSCHRIFT

(11) **EP 0 866 650 B1**
(45) Veröffentlichungstag und Bekanntmachung des Hinweises auf die Patenterteilung: **25.06.2003**
(21) Anmeldenummer: 98105156.8
(22) Anmeldetag: 21.03.1998
(51) Int. Cl.: H05K 9/00

(54) **Anordnung zur hochfrequenzdichten Abschirmung**
High frequency shielding device
Dispositif de blindage hautes fréquences

(30) Priorität: 21.01.1998 DE 19802162; 22.03.1997 DE 19712146
(43) Veröffentlichungstag der Anmeldung: 23.09.1998
(73) Patentinhaber: Intermas-Elcom GmbH, 67304 Eisenberg (DE)
(72) Erfinder: Ponto, Robert, 63500 Seligenstadt (DE); Bohnenberger, Willy, 63533 Mainflingen (DE); Haxel, Gerd, 63500 Seligenstadt (DE)
(74) Vertreter: Stoffregen, Hans-Herbert, Dr. Dipl.-Phys. Patentanwalt

(56) Entgegenhaltungen:
- EP-A- 0 516 986
- DE-C- 19 544 835
- DE-C- 19 614 692
- DE-U- 29 706 673
- US-A- 4 803 306

## Beschreibung

Die Erfindung bezieht sich auf eine Anordnung zur hochfrequenzdichten Abschirmung von Wandungen oder Teilen dieser eines Gehäuses, insbesondere von Frontplatten eines Baugruppenträgers, wobei die Wandungen oder deren Teile jeweils ein eine Abschirmfunktion aufweisendes plattenförmiges Basiselement mit gegebenenfalls von diesem in das Gehäuse hineinragenden Wandschenkeln umfassen, wobei zumindest in einem senkrecht zur Frontfläche des Basiselementes verlaufenden Seitenrandbereich eine (erste) Aufnahme wie Nut mit zur Frontfläche naheliegender bzw. fernliegender Seitenwand sowie Boden wie Nutgrund verläuft, in der ein im Schnitt U-förmiger erster Schenkel eines Federelementes verläuft, das sich mit einem weiteren Schenkel bereichsweise entlang des Seitenrandbereichs erstreckt.

Bei bekannten Baugruppenträgern werden zur Abschirmung des Innenraums gegen äußere elektromagnetische Felder und des Bereichs außerhalb des Baugruppenträgers vor im Baugruppeninneren erzeugten elektromagnetischen Feldern im Bereich der Frontplatten Blattfedern benutzt, die einen sogenannten von der Frontplatte ausgehenden und in das Gehäuseinnere erstreckenden Federschenkel umgeben, um mit ihren freien Enden jeweils in einer in jeder Seite des Federschenkels verlaufenden Nut einzugreifen (DE 41 14 484 C2).

Dabei kann der nach außen gewölbte Federschenkel in leitenden Kontakt mit einer Kontaktleiste einer angrenzenden Frontplatte gelangen, wodurch die erforderliche Hochfrequenzdichtheit gewährleistet ist (DE 36 04 860 C2).

Aus der EP 0 401 418 B1 ist eine Abschirmeinrichtung für eine elektrische Baugruppe bekannt, bei der ein als Schirmblech ausgebildetes Kontaktblech die gesamte Frontplatte überdeckt und mit den Schirmblechen der benachbarten Frontplatten unmittelbar kontaktierbar ist.

Bei einer Anordnung der eingangs genannten Art greift ein Federelement mit seinem Klemmblatt in eine in einer Schmalseite einer Platte verlaufenden Nut ein. Von dem Klemmblatt selbst geht rechtwinklig ein Federblatt mit einem Fußteil und einem Kontaktteil aus. Das Kontaktteil ist in sich zurückgebogen und trägt eine Kontaktrippe, welche das entsprechende Kontaktteil eines benachbarten Bauteiles kontaktiert (DE 195 44 835 C1).

Ein entsprechendes Federelement weist eine aufwendige Geometrie auf, wobei sichergestellt sein muss, dass das Fußteil plan entlang der Schmalseite verläuft, da andernfalls mehrere Frontplatten nicht im erforderlichen geringen Abstand aneinander gereiht werden können. Damit das Federelement in der Nut verbleibt, muss das Klemmblatt in seinen Ecken als Federkralle ausgebildet sein. Hierdurch wird jedoch nicht stets sichergestellt, dass die erforderliche Fixierung in der Nut erfolgt.

Der vorliegenden Erfindung liegt das Problem zu Grunde, eine Anordnung der zuvor beschriebenen Art so weiterzubilden, dass eine hinreichende Abschirmfunktion mit einer eine einfache Geometrie aufweisenden Feder ermöglicht wird, die sicher fixierbar ist, ohne dass es einer besonders aufwendigen Geometrie der Feder selbst bedarf. Auch soll die Feder gleichermaßen in Blechfrontplatten als auch Profilfrontplatten einsetzbar sein, ohne dass die Feder selbst eine Behinderung beim Hineinschieben oder Herausziehen benachbarter Baugruppen, insbesondere bei einem Hängenbleiben von Beinen benachbarter Leiterplatten bildet. Insbesondere soll dabei die als Nut ausgebildete Aufnahme für das Federelement in einem einzigen Arbeitsgang z. B. durch Fräsen hergestellt werden können.

Erfindungsgemäß wird die Aufgabe zum einen dadurch gelöst, dass der erste im Schnitt U-förmige Schenkel des Federelementes in seinem vorderen freien Querrandbereich zumindest einen in oder im Wesentlichen in vom äußeren Schenkelabschnitt aufgespannter Ebene verlaufenden sich an der zur Frontfläche naheliegender Seitenwand der ersten Aufnahme abstützenden Abschnitt aufweist und dass der weitere Schenkel des Federelementes ein zweiter U-förmiger Schenkel ist, der einen in Richtung des ersten U-förmigen Schenkels gebogenen Randabschnitt aufweist. Insbesondere ist vorgesehen, dass der vordere Querrandbereich des ersten U-förmigen Schenkels einen V-förmigen Verlauf aufweist.

Nach einer weiteren Ausgestaltung ist vorgesehen, dass der vordere Querrandbereich zumindest einen in der Ebene verlaufenden Vorsprung wie Spitze als der Abschnitt aufweist. Auch kann vorgesehen sein, dass vom jeweiligen Längsrand des äußeren Schenkelabschnitts ausgehend im äußeren Querrandbereich ein dachförmiger Ausschnitt vorgesehen ist.

Dadurch, dass der sich innerhalb der Aufnahme erstreckende erste Abschnitt des Federelementes mit seinem vorzugsweise spitzenartigen Abschnitt bzw. Vorsprung sich an der zur Frontfläche naheliegenden Seitenwand abstützt, erfolgt ein Verkeilen derart, dass die Feder in einem Umfang gesichert ist, dass ein unkontrolliertes Lösen nicht möglich ist. Somit ist eine Feder mit einfacher Geometrie nutzbar, die problemlos in der Aufnahme wie Nut einbringbar und dort verkeilbar ist.

Dabei sollte bevorzugterweise bei in der ersten Aufnahme eingebrachtem ersten U-förmigen Schenkel der vordere freie Schenkelabschnitt in einer Ebene verlaufen, die die der Frontplatte naheliegende Seitenwandung unter einem Winkel β mit 60° ≥ β ≥ 30°, insbesondere β ≈ 45° schneidet. Entsprechend sind die Abmessungen der Breite der Aufnahme zu den Abschnitten des ersten U-förmigen Schenkels zu wählen.

Insbesondere sollte bei entspanntem Federelement der freie äußere Querrand des äußeren Schenkels des zweiten U-förmigen Schenkels in oder in etwa in einer Ebene verlaufen, die vom Übergangsbereich zwischen dem ersten und dem zweiten U-förmigen Schenkel und freien äußeren Querrand des ersten U-förmigen Schenkels aufgespannt ist.

Im eingebautem Zustand sollte die Feder innerhalb senkrechter Projektion der zur Frontplatte naheliegenden Seitenwandung der ersten Aufnahme wie Nut verlaufen. Gegebenenfalls kann sogar der in Richtung des ersten U-förmigen Schenkels gebogene Randbereich des zweiten U-förmigen Schenkels mit seinem freien Querrand innerhalb des von dem ersten U-förmigen Schenkel umgebenen Raums verlaufen.

Nach einem alternativen Lösungsvorschlag ist vorgesehen, dass von der zur Frontfläche naheliegenden Seitenwandung der im Seitenrandbereich des Basiselementes verlaufenden ersten Aufnahme wie Nut ein Vorsprung ausgeht, dass sich der U-förmige erste Schenkel des Federelementes mit seinem freien Ende zwischen dem Vorsprung und dem Boden der Aufnahme wie Nutgrund erstreckt und dass der weitere Schenkel des Federelementes ein zweiter U-förmiger Schenkel ist, der einen in Richtung des ersten Schenkels gebogenen Randabschnitt aufweist, der sich vorzugsweise innerhalb vom von dem ersten U-förmigen Schenkel umgebenen Raum, also zwischen dessen ein V einschließenden Schenkelabschnitten erstreckt.

Auch nach diesem Lösungsvorschlag wird ein Federelement zur Verfügung gestellt, das aus zwei ineinander übergehenden U-förmigen Schenkeln besteht, die ihrerseits einen spitzen Winkel einschließen, wobei sich das freie Ende des äußeren Schenkelabschnitts des zweiten U-förmigen Schenkels zwischen den Schenkelabschnitten des ersten U-förmigen Schenkels erstrecken kann. Somit verläuft der freie Querrand des zweiten U-förmigen Schenkels bei in die Aufnahme wie Nut eingebrachtem ersten U-förmigen Schenkels in ersterer, so dass zum Beispiel beim Hineinschieben bzw. Herausziehen benachbarter Basiselemente bzw. durch von diesen ausgehende Baugruppenträger eine Behinderung bzw. ein Hängenbleiben ausgeschlossen ist.

Dadurch, dass der äußere Schenkelabschnitt des ersten U-förmigen Schenkels des Federelementes durch den von der frontflächenseitigen Wand der Nut ausgehenden Vorsprung gesichert ist, kann ein unkontrolliertes Herausgleiten des Federelementes aus der Nut nicht erfolgen, selbstverständlich unter der Voraussetzung, dass der Abstand der Seitenschenkel des ersten U-förmigen Schenkels im entspannten Zustand des Federelementes größer als der Abstand der Wände der ersten Nut ist.

In Weiterbildung der erfindungsgemäßen Lehren ist vorgesehen, dass der in Richtung des ersten U-förmigen Schenkels verlaufende Querrandbereich des äußeren Schenkelabschnitts des zweiten U-förmigen Schenkels im Abstand vom Scheitelbereich des zweiten U-förmigen Schenkels gebogen ist, der in etwa gleich dem Abstand zwischen dem Scheitelbereich und Übergang zwischen den inneren Schenkelabschnitten von dem ersten und zweiten U-förmigen Schenkel ist. Hierdurch ergibt sich eine vorteilhafte Federcharakteristik, d. h., das Federelement kann eine gewünschte weiche Federcharakteristik aufweisen, wodurch zusätzlich das Hineinschieben und Herausziehen benachbarter Basiselemente nicht behindert wird.

Die Länge des ersten U-förmigen Schenkels ist kleiner als die des zweiten U-förmigen Schenkels. Vorzugsweise verhalten sich die Längen wie 1 : 1,5 bis 1 : 3, vorzugsweise in etwa 1 : 2.

In eigenerfinderischer Weiterbildung ist vorgesehen, dass der Scheitelbereich des zweiten U-förmigen Schenkels in einer zweiten Aufnahme wie Nut eines in das Gehäuse sich hineinerstreckenden Wandschenkels des Basiselementes verläuft. Durch den Wandschenkel erfolgt eine Versteifung des Basiselements. Gleichzeitig bietet der Wandschenkel einen Schutz für das Federelement. Somit ist eine robuste Handhabung möglich.

Unabhängig davon kann das erfindungsgemäß ausgebildete Federelement gleichermaßen in Basiselementen eingesetzt werden, die als Blechfrontplatten oder als Profilfrontplatten ausgebildet sind.

Sofern sowohl der Scheitelbereich des ersten U-förmigen Schenkels als auch der des zweiten U-förmigen Schenkels jeweils in einer Aufnahme wie Nut verläuft, sollten deren Mittelachsen einen spitzen Winkel zueinander beschreiben.

Des Weiteren ist vorgesehen, dass die zur Frontfläche naheliegende Seitenwandung der ersten Nut eine größere Tiefe als die zu der Frontfläche fernliegende Seitenwandung aufweist.

Hierdurch wird die Möglichkeit geschaffen, mit einfachen Maßnahmen den von der zur Frontfläche naheliegenden Seitenwandung ausgehenden Vorsprung wie Nase durch Bearbeitung der Seitenwandinnenfläche auszubilden. Die Ausbildung der Nase erfolgt insbesondere bei stranggepreßten Teilen. Sofern diese durch Fräsen gebildet wird, entfällt grundsätzlich der Vorsprung.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: einen Ausschnitt einer ersten Ausführungsform einer Profilfrontplatte mit eingesetztem Federelement, im Schnitt,
- Fig. 2: einen Ausschnitt einer ersten Ausführungsform einer Blechfrontplatte mit eingesetztem Federelement, im Schnitt,
- Fig. 3: einen Abschnitt von aneinanderhängenden Federelementen einer ersten Ausführungsform,
- Fig. 4: einen Querschnitt eines Federelementes nach Fig. 3,
- Fig. 5: einen Zuschnitt einer zweiten Ausführungsform von aneinanderhängenden Federelementen,
- Fig. 6: die aus dem Zuschnitt der Fig. 5 gebogenen Federelemente in Vorderansicht,
- Fig. 7: eine Seitenansicht der gebogenen Federelemente,
- Fig. 8: einen Schnitt entlang der Linie AB in Fig. 6 in vergrößerter Darstellung,
- Fig. 9: eine Ausführungsform einer Flachfrontplatte im Ausschnitt,
- Fig. 10: eine weitere Ausführungsform eines Frontplattenprofils und
- Fig. 11: im Ausschnitt ein Flanschprofil einer Seitenwand eines Baugruppenträgers.

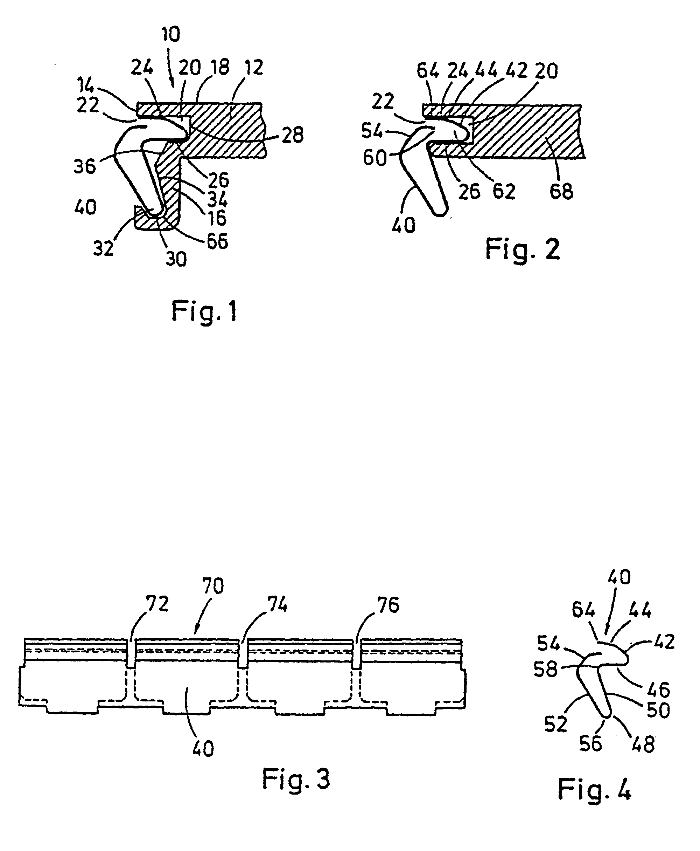

Gehäuse, die für die Hochfrequenztechnik bestimmt sind, müssen hochfrequenzdicht ausgeführt sein. Dabei muss sichergestellt sein, dass sowohl die von dem in dem Gehäuse angeordneten Baugruppen erzeugte elektromagnetische Strahlung nicht nach außen gelangt als auch elektromagnetische Strahlung nicht in das Gehäuse eindringen kann. Dies bedeutet, dass zwischen Gehäusewandungen bzw. Frontplatten vorhandene Fugen hochfrequenzdicht ausgebildet sein müssen. Eine entsprechende Abdichtung mittels Blattfedern wird anhand der Fig. 1 bis 11 erläutert, wobei die verwendeten Blattfedern Frontplatten zueinander bzw. gegenüber Gehäusewandungen abdichten. Hierdurch soll jedoch eine Einschränkung der erfindungsgemäßen Lehre nicht erfolgen. Vielmehr ist eine Anwendung überall dort möglich, wo Fugen gegenüber elektromagnetischer Strahlung abgedichtet werden sollen.

In den Fig. 1 bis 4 und 5 bis 11 sind verschiedene Ausführungsformen von Ausgestaltungen von Gehäuseabschnitten bzw. Frontplatten und diese gegeneinander abschirmende Federelemente dargestellt.

So ist in Fig. 1 ein Ausschnitt einer Profilfrontplatte 10 gezeichnet. Diese weist ein als Frontplatte 12 bezeichnetes Basiselement mit einem von dessen einem Längsrand 14 ausgehenden und im eingebauten Zustand in das Innere eines Gerätes ragenden, auch als Federschenkel zu bezeichnenden Wandschenkel 16 auf. Von dem gegenüberliegenden Längsrand der Frontplatte 12 kann ein entsprechender Federschenkel 16 oder ein Kontaktschenkel ausgehen, der mit einem Federelement einer benachbarten Frontplatte in elektrisch leitender Verbindung steht.

Parallel zur Frontfläche 18 der Frontplatte 12 verlaufend und von dessen Längsrand 14 ausgehend ist eine erste Nut 20 vorhanden, die im Bereich ihres vorderen Randes, also von dem Längsrand 14 ausgehend einen nasenartigen Vorsprung 22 aufweist. Dieser erstreckt sich über die gesamte Länge der frontflächenseitigen Wand 24 der Nut 20. Die Tiefe der zur Frontfläche 18 fernliegenden Begrenzungswand 26 der Nut 20 ist geringer als die gegenüberliegende Wand 24. Die Wände 24, 26 gehen über einen Nutgrund 28 ineinander über.

In dem Federschenkel 16 ist eine weitere Nut 30 vorhanden, deren außenseitige Wand 32 im Schnitt V-förmig ausgebildet und erheblich kürzer als die innenliegende Wand 34 ist, die über eine unter einem stumpfen Winkel zu der Wand 34 verlaufende Schräge 36 in die zur Frontfläche 18 fernliegende Wand 26 der ersten Nut 20 übergeht. In die Aufnahmen bildenden ersten und zweiten Nuten 20, 30 wird ein Blattfederelement 40 eingesetzt, das im Schnitt eine Sichelform aufweist und einen ersten U-förmigen Abschnitt 42 mit äußerem Schenkelabschnitt 44 und innerem Schenkelabschnitt 46 und einen von dem ersten U-förmigen Schenkel 42 ausgehenden zweiten U-förmigen Schenkel 48 umfasst, ebenfalls mit innerem Schenkelabschnitt 50 und äußerem Schenkelabschnitt 52. Die ineinander übergehenden inneren Schenkelabschnitte 46 und 50 beschreiben einen spitzen Winkel zueinander, vorzugsweise einen Winkel von in etwa 50° bis 70°, vorzugsweise in etwa 60°.

Der erste U-förmige Schenkel 42 weist eine geringere Länge als der zweite U-förmige Schenkel 50 auf. Vorzugsweise verhalten sich die Schenkellängen wie 1 : 1,5 bis 1: 3, insbesondere 1 : 2.

Der äußere Schenkelabschnitt 52 des zweiten U-förmigen Schenkels 48 weist einen in Richtung des ersten U-förmigen Schenkels 42 gebogenen Randabschnitt 54 auf. Die Biegelinie, um die der Randabschnitt 54 in Richtung des ersten U-förmigen Schenkels 42 gebogen ist, verläuft im Abstand zum Scheitelbereich 56 zwischen dem inneren und äußeren Schenkelabschnitt 50 und 52, der in etwa gleich der Länge des Abstands zwischen dem Scheitelbereich 56 und dem Übergangsbereich 58 zwischen dem ersten und zweiten U-förmigen Schenkeln 42, 48, also zwischen den ineinanderübergehenden inneren Schenkelabschnitten 46 und 50 ist.

Das freie Ende 60 des in Richtung des ersten Schenkels 42 gebogenen Randabschnitts 54 sollte in dem zwischen den inneren und äußeren Schenkelabschnitten 46, 54 des ersten U-förmigen Schenkels 42 gebildeten Raum 62 verlaufen. Folglich ist das freie Ende 60 vom freien Ende 64 des äußeren Schenkels 44 des ersten U-förmigen Schenkels 42 abgedeckt.

Wird das Federelement 40 in die erste und zweite Nut 20, 30 eingesetzt, so erfolgt ein Verrasten des ersten U-förmigen Schenkels 42 dadurch, dass der vordere freie Rand 64 durch den Vorsprung 22 zurückgehalten wird, der die Funktion einer Arretierung ausübt. Somit ist sichergestellt, dass das Federelement 40 nicht unkontrolliert aus der ersten Nut 22 herausgleiten kann, so dass folglich das Federelement 40 gesichert ist.

Der zweite U-förmige Schenkel 48 wird mit seinem Scheitelbereich 48 von der zweiten Nut 30 aufgenommen und somit geschützt. Gegebenenfalls kann zwischen Nutgrund 66 der zweiten Nut 30 und dem Schenkel 48 in seinem Scheitelbereich ein Abstand sein.

Aber auch dann, wenn der zweite U-förmige Schenkel 48 nicht in einer Nut 30 verläuft, ist das Federelement 40 durch die erste Nut 20 im hinreichenden Umfang gesichert, und zwar aufgrund des als Nase zu bezeichnenden und über die gesamte Länge des Profilelementes 12 verlaufenden randseitigen Vorsprungs 64.

Daher ist das erfindungsgemäß ausgebildete Federelement 40 auch in einer Blechfrontplatte 68 einsetzbar, wie dies anhand der Fig. 2 verdeutlicht wird. So wird der äußere Schenkelabschnitt 44 in der Nut 20 entweder durch Eigenvorspannung und Verrastung oder durch die Nase 44 gehalten, unter der Voraussetzung, dass der U-förmige erste Schenkel 42 eine Weite im Bereich des vorderen Randes aufweist, die größer als die der Nut 20 ist.

Das Federelement 40 weist im Schnitt eine Art Nieren- oder Sichelform auf, die aufgetrennt ist, damit ein Längsrand an dem Vorsprung 44 der frontseitigen Wand 24 der Nut 20 anstoßen und damit das Federelement 40 sichern kann.

Das Federelement 40 ist einstückig durch Ausstanzen aus einem Blechstreifen 70 hergestellt. Dabei ist der Blechstreifen 70 durch Ausschnitt 72, 74, 76 in Abschnitte unterteilt, die jeweils im Schnitt eine Geometrie aufweisen, die der des in Fig. 1, 2 und 4 dargestellten Federelementes 40 entspricht. Somit wird eine Blattfeder zur Verfügung gestellt, die sich über die gesamte Länge der Nut 20 bzw. der Nuten 20, 30 erstreckt, und zwar z. B. über die gesamte Höhe des Innenraums eines Gehäuses, welches z. B. von Frontplatten 12, 68 abgeschirmt werden soll.

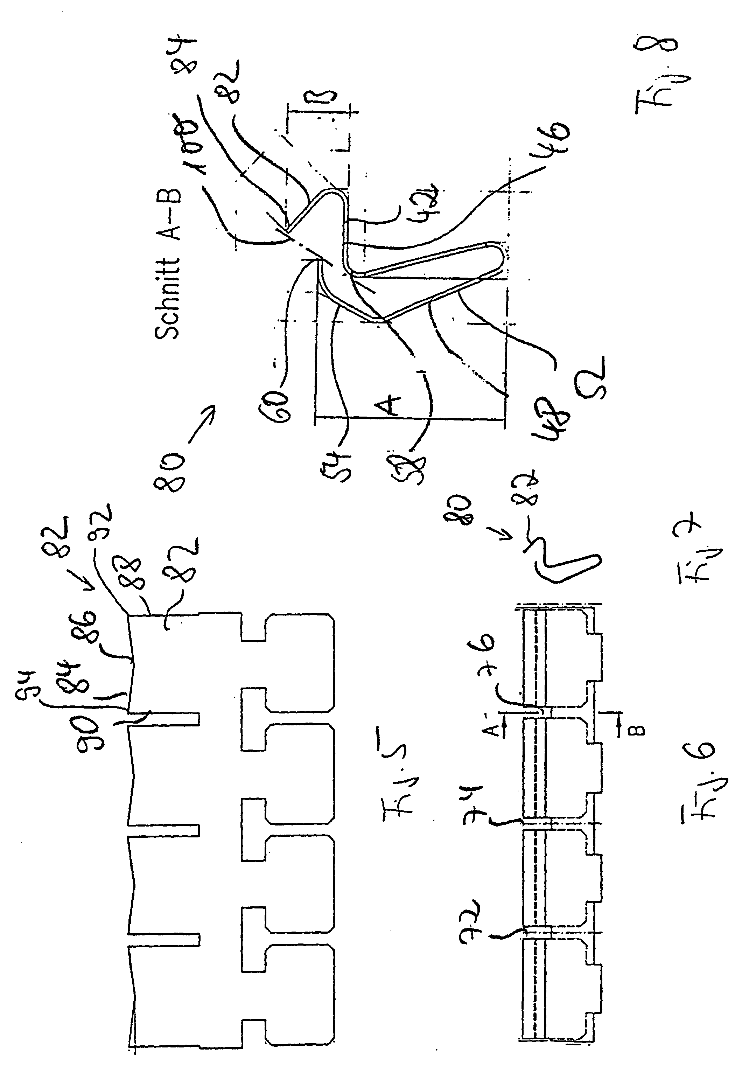

In den Fig. 5 bis 11 sind besonders hervorzuhebende Ausführungsformen der Erfindung zu entnehmen, wobei für Elemente, die denen der Fig. 1 und 4 entsprechen, grundsätzlich gleiche Bezugszeichen verwendet werden. Die den Fig. 5 bis 11 zu entnehmenden Federelemente 80 sind ebenfalls Abschnitte eines Zuschnitts 82 eines Blechstreifens, der - wie ein Vergleich der Fig. 5 und 6 zeigt - durch Biegen die gewünschte Geometrie erlangt. Folglich bilden die Federelemente 80 Abschnitte einer Blattfeder, die durch Ausschnitte 72, 74, 76 im erforderlichen Umfang getrennt sind.

Die einzelnen Federelemente 80 weisen eine offene Nieren- bzw. Bananenform entsprechend der Blattfeder 40 auf, wobei jedoch der erste U-förmige Schenkel 42 im freien äußeren Querrandbereich 84 des äußeren Schenkelabschnitts 82 einen V- bzw. dachförmigen Ausschnitt 86 oder eine funktional gleichwirkende Geometrie aufweist, so dass infolgedessen vom jeweiligen Längsrand 88, 90 des Schenkelabschnitts 82 ausgehend ein Abschnitt wie spitzenartige Vorsprünge 92, 94 ausgebildet ist, die in der von dem äußeren Schenkelabschnitt 82 aufgespannten Ebene verlaufen.

Durch die Gestaltung des Querrandes 84 des Schenkelabschnitts 82 wird die Möglichkeit geschaffen, dass bei in die erste Nut 20 der Profilfrontplatte 10 bzw. der Blechfrontplatte 68 bzw. eines Seitenwandabschlussprofils 94 eingebrachter Feder 80 ein Verkeilen bzw. Verrasten derart erfolgt, dass das Federelement 80 im erforderlichen Umfang gesichert ist, ohne dass der den Fig. 1 und 2 zu entnehmende Vorsprung in der frontseitigen Seitenwandung 24 der Nut 20 benötigt wird.

Das Verhaken des Querrandbereichs 84 aufgrund vorzugsweise der haken- bzw. spitzenartigen Vorsprünge 92, 94 erfolgt insbesondere dann im notwendigen Umfang, wenn die von dem äußeren Schenkelabschnitt 82 des ersten U-förmigen Schenkels 42 des Federelementes 80 aufgespannte Ebene 98 die Innenfläche 96 der Seitenwandung 24 unter einem Winkel β mit insbesondere 60° ≥ β ≥ 20°, insbesondere 45° ≥ β ≥ 30° schneidet.

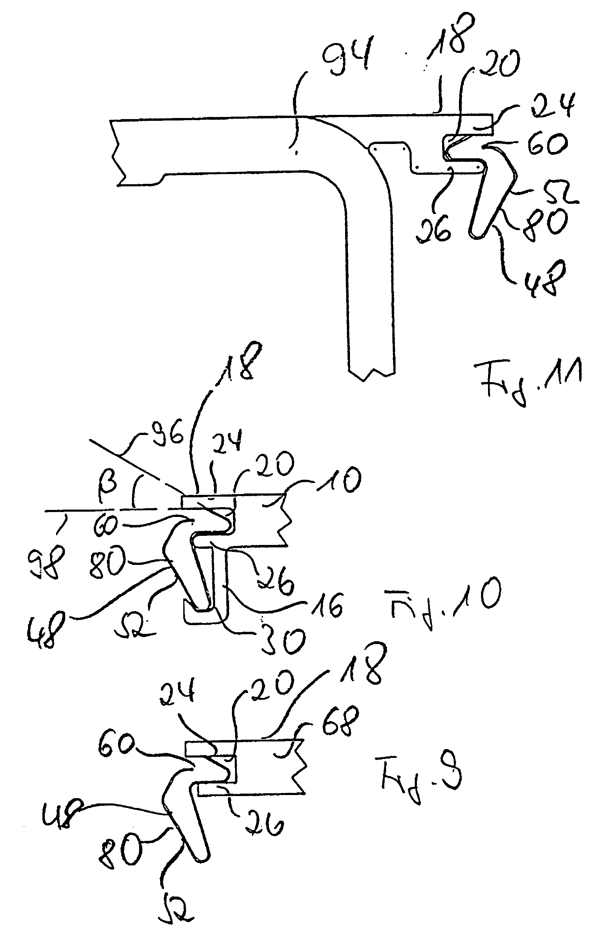

Aus der Schnittdarstellung der Fig. 8 ergeben sich weitere hervorzuhebende Merkmale des Federelementes 80. So verläuft im entspannten Zustand des Federelementes 80 der freie Querrand 60 des äußeren Schenkelabschnitts 54 des zweiten U-förmigen Schenkels 48 in oder nahezu in einer Ebene 100, die durch den Querrandbereich 84 des ersten U-förmigen Schenkels 42 und dem Übergangsbereich 58 zwischen ersten und zweiten U-förmigen Schenkel 42, 48 aufgespannt wird.

Durch diese Dimensionierung ergibt sich, dass bei in die Nut 20 eingebrachtem Federelement 80 der freie Querrand 60 des zweiten, also im eingebautem Zustand äußeren U-förmigen Schenkelabschnitts 52 nicht zwingend innerhalb des von dem ersten U-förmigen Schenkel 42 umgebenen Raumes verlaufen muss, sondern allein innerhalb der Nut 20 derart, dass der freie Rand 60 innerhalb der senkrechten Projektion der Seitenwandung 24 der Nut 20 verläuft. Hierdurch ist sichergestellt, dass z. B. beim Hineinschieben bzw. Herausziehen benachbarter Frontplatten bzw. Baugruppenträgern eine Behinderung bzw. ein Hängenbleiben an dem Federelement 80 ausgeschlossen ist. Nimmt man die von dem inneren Schenkelabschnitt 46 des ersten U-förmigen Schenkels 42 aufgespannte Ebene, als Bezugsfläche, so weist der zweite U-förmige Schenkel 48 in einer zu der Bezugsfläche 46 parallel verlaufenden Projektion eine Höhe A auf, die sich zu der entsprechenden Projektion B des ersten U-förmigen Schenkels 42 verhält wie A : B wie in etwa 3 : 1.

Die Länge des inneren Schenkelabschnitts 46 des ersten U-förmigen Schenkels 42 sollte sich zur Länge des äußeren den V-förmig verlaufenden Querrandbereich 84 aufweisenden Schenkelabschnitts 82 verhalten wie in etwa 1,35 : 1.

Ansonsten ergeben sich für das Federelement 80 gemäß der Fig. 5 bis 11 die gleichen Vorteile, wie die Konstruktion der Fig. 1 bis 4.

Aus den Fig. ergibt sich des Weiteren, dass der freie Querrand 60 des zweiten U-förmigen Schenkels 52 sowohl im entspannten Zustand als auch im eingebauten Zustand des Federelementes 80 in Richtung des ersten U-förmigen Schenkels 42 derart versetzt verläuft, dass der Übergangsbereich 58 zwischen dem ersten und zweiten U-förmigen Schenkel 42, 48 unterhalb der Projektion des äußeren Schenkelabschnitts 56 verläuft, betrachtet in einer senkrecht zur Bezugsebene 46 verlaufenden Richtung.

## Patentansprüche

1. Anordnung zur hochfrequenzdichten Abschirmung von Wandungen oder Teilen dieser eines Gehäuses, insbesondere von Frontplatten (10) eines Baugruppenträgers, wobei die Wandungen oder deren Teile jeweils ein eine Abschirmfunktion aufweisendes plattenförmiges Basiselement (12) mit gegebenenfalls von diesem in das Gehäuse hineinragenden Wandschenkeln (16) umfassen, und wobei in zumindest einem senkrecht zur Frontfläche (18) des Basiselementes sich erstreckenden Seitenrandbereich (14) eine erste Aufnahme wie Nut (20) mit zur Frontfläche naheliegender bzw. fernliegender Seitenwand (24, 26) sowie Boden wie Nutgrund (28) verläuft, in die ein im Schnitt U-förmiger erster Schenkel (42) eines Federelementes (80) einbringbar ist, das sich mit einem weiteren Schenkel (48) bereichsweise entlang des Seitenrandbereichs erstreckt,
**dadurch gekennzeichnet,**
**dass** der erste im Schnitt U-förmige Schenkel (42) des Federelementes (80) in seinem vorderen freien Querrandbereich (84) zumindest einen in oder im Wesentlichen in vom äußeren Schenkelabschnitt (82) aufgespannter Ebene verlaufenden sich an der zur Frontfläche (18) naheliegenden Seitenwand (24) der ersten Aufnahme (20) abstützenden Abschnitt (92, 94) aufweist und dass der weitere Schenkel des Federelementes ein zweiter U-förmiger Schenkel (48) ist, der einen in Richtung des ersten U-förmigen Schenkels gebogenen Randabschnitt (54) aufweist.

2. Anordnung nach Anspruch 1,
**dadurch gekennzeichnet,**
**dass** der vordere Querrandbereich (84) einen V-förmigen Verlauf und vorzugsweise zumindest eine einen in der Ebene verlaufenden Vorsprung bildende Spitze (92, 94) als der Abschnitt aufweist.

3. Anordnung nach zumindest einem der vorhergehenden Ansprüche,
**dadurch gekennzeichnet,**
**dass** vom jeweiligen Längsrand (88, 90) des äußeren Schenkelabschnitts (82) des ersten U-förmigen Schenkels (42) ausgehend der äußere Querrandbereich (84) einen dachförmigen Ausschnitt (86) aufweist.

4. Anordnung nach zumindest einem der vorhergehenden Ansprüche,
**dadurch gekennzeichnet,**
**dass** bei in die erste Aufnahme wie Nut (20) eingebrachtem ersten U-förmigen Schenkel (42) dessen äußerer Schenkelabschnitt (82) in einer Ebene (96) verläuft, die die zur Frontfläche naheliegende Seitenwandung (24) unter einem Winkel β mit vorzugsweise 60° ≥ β ≥ 20°, insbesondere 45° ≥ β ≥ 30° schneidet.

5. Anordnung nach zumindest einem der vorhergehenden Ansprüche,
**dadurch gekennzeichnet,**
**dass** bei entspanntem Federelement (80) der freie äußere Querrand (60) des zweiten U-förmigen Schenkels (48) in oder in etwa in einer Ebene verläuft, die vom Übergangsbereich (58) zwischen dem ersten und dem zweiten U-förmigen Schenkel und Querrandbereich (84) des ersten U-förmigen Schenkels (42) aufgespannt ist.

6. Anordnung nach zumindest einem der vorhergehenden Ansprüche,
**dadurch gekennzeichnet,**
**dass** der in Richtung des ersten U-förmigen Schenkels (42) gebogene Randbereich (54) des zweiten U-förmigen Schenkels (48) mit seinem freien Rand (60) im Bereich senkrechter Projektion der die erste Aufnahme (20) frontflächenseitig begrenzenden Seitenwandung (24) verläuft.

7. Anordnung nach zumindest einem der vorhergehenden Ansprüche,
**dadurch gekennzeichnet,**
**dass** von der zur Frontfläche (18) des Basiselementes (12) naheliegenden Seitenwandung (24) der im Seitenrandbereich (14) verlaufenden ersten Nut (20) ein Vorsprung (22) ausgeht, dass sich der erste im Schnitt U-förmige Schenkel (42) des Federelementes(14) mitseinemfreien Ende (64) zwischen dem Vorsprung und dem Nutgrund (28)erstreckt und dass der weitere Schenkel des Federelementes ein zweiter U-förmiger Schenkel (48) ist, der einen in Richtung des ersten U-förmigen Schenkels gebogenen Randabschnitt (54) aufweist.

8. Anordnung nach zumindest einem der vorhergehenden Ansprüche,
**dadurch gekennzeichnet,**
**dass** der in Richtung des ersten U-förmigen Schenkels (42) gebogene Randbereich (54) des zweiten U-förmigen Schenkels (48) mit seinem freien Rand (60) innerhalb des von dem ersten U-förmigen Schenkel umgebenen Raums (62) erstreckt.

9. Anordnung nach zumindest einem der vorhergehenden Ansprüche,
**dadurch gekennzeichnet,**
**dass** der erste und der zweite U-förmige Schenkel (42, 48) in Bezug auf ihre ineinanderiibergehenden inneren Schenkelabschnitte (46, 50) einen spitzen Winkel einschließen.

10. Anordnung nach einem der vorhergehenden Ansprüche,
**dadurch gekennzeichnet,**
**dass** die ineinanderübergehenden inneren Schenkelabschnitte (46, 50) des ersten und zweiten U-förmigen Schenkels (42, 48) einen Winkel von in etwa 50° bis 70°, vorzugsweise in etwa 60° einschließen.

11. Anordnung nach einem der vorhergehenden Ansprüche,
**dadurch gekennzeichnet,**
**dass** die Länge des ersten U-förmigen Schenkels (42) kleiner als der des zweiten U-förmigen Schenkels (48) ist, wobei sich die Längen der Schenkel in etwa verhalten wie 1 : 1,4 bis 1 : 3,0, insbesondere in etwa 1 : 2.

12. Anordnung nach einem der vorhergehenden Ansprüche,
**dadurch gekennzeichnet,**
**dass** der Randbereich (54) des äußeren Schenkelabschnitts (52) des zweiten U-förmigen Schenkels (48) im Abstand zu dessen Scheitelbereich (56) in Richtung des ersten U-förmigen Schenkels (42) gebogen ist, der in etwa gleich dem Abstand zwischen dem Scheitelpunkt und Übergang zwischen den inneren Schenkelabschnitten (46, 50) von dem ersten und zweiten U-förmigen Schenkel (42, 48) ist.

13. Anordnung nach einem der vorhergehenden Ansprüche,
**dadurch gekennzeichnet,**
**dass** der Scheitelbereich (56) des zweiten U-förmigen Schenkels (48) in einer zweiten Aufnahme wie Nut (30) eines sich in das Gehäuse hineinerstreckenden Wandschenkels (16) des Basisabschnitts (12) verläuft.

14. Anordnung nach einem der vorhergehenden Ansprüche,
**dadurch gekennzeichnet,**
**dass** die erste und zweite Nut (20, 30) bzw. deren Mittelachsen einen spitzen Winkel einschließen, der in etwa dem Winkel entspricht, den der erste und zweite U-förmige Schenkel (42, 48) mit seinen Mittelachsen einschließt.

15. Anordnung nach einem der vorhergehenden Ansprüche,
**dadurch gekennzeichnet,**
**dass** die zur Frontfläche (18) fernliegende Seitenwand (26) der ersten Nut (28) eine geringere Tiefe als die zur Frontfläche naheliegende Seitenwand (24) aufweist.

16. Anordnung nach einem der vorhergehenden Ansprüche,
**dadurch gekennzeichnet,**
**dass** das Basiselement (12, 94) eine Blechfrontplatte oder ein Teil einer im Schnitt vorzugsweise U- oder L-förmige Profilfrontplatte oder ein Abschnitt eines Seitenwandabschlussprofils ist.

## Claims

1. Arrangement for high-frequency opaque shielding of walls, or portions thereof, of a housing, in particular of front panels (10) of a sub-rack, wherein the walls or their portions comprise each a plate-form basic element (12) having a shielding function, with wall legs (16) projecting, if appropriate, from these into the housing, and wherein in at least one side margin region (14) extending perpendicularly to the front face (18) of the basic element extends a first reception, such as groove (20), with a sidewall (24, 26) in the proximity of the front face or disposed remote from it, as well as a bottom, such as groove bottom (28), into which a fist leg (42), U-form in section, of a spring element (80) can be emplaced which extends with a further leg (48) in regions along the side margin region,
**characterized in**
**that** the first leg (42), U-form in section, of spring element (80) comprises in its front free transverse peripheral region (84) at least one segment (92, 94) extending in or substantially in a plane defined by the outer leg segment (82) and supported on the side wall (24), disposed in the proximity of the front face (18) of the first reception (20), and that the further leg of the spring element is a second U-form leg (48) which comprises a peripheral segment (54) bent in the direction of the first U-form leg.

2. Arrangement according to claim 1,
**characterized in**
**that** the front transverse peripheral region (84) has a V-form course and preferably at least one projection extending in the plane and forming a point (92, 94) as the segment.

3. Arrangement according to at least one of the preceding claims,
**characterized in**
**that** starling from the particular longitudinal edge (88, 90) of the outer leg segment (82) of the fist U-form leg (42) the outer transverse peripheral region (84) comprises a roof-form cut-out (86).

4. Arrangement according to at least one of the preceding claims,
**characterized in**
**that** with the first U-form leg (42) emplaced in the first reception as groove (20) its outer leg segment (82) extends in a plane (96) which intersects the sidewall (24) disposed in the proximity of the front face at an angle β of preferably 60° ≥ β ≥ 20°, in particular 45° ≥ β ≥ 30°.

5. Arrangement according to at least one of the preceding claims,
**characterized in**
**that** with the spring element (80) released, the free outer transverse edge (60) of the second U-form leg (48) extends in or approximately in a plane which is defined by the transition region (58) between the first and the second U-form leg and transverse peripheral region (84) of the first U-form leg (42).

6. Arrangement according to at least one of the preceding claims,
**characterized in**
**that** the peripheral region (54), bent in the direction of the first U-form leg (42) of the second U-form leg (48) extends with its free edge (60) in the region of perpendicular projection of sidewall (24) bounding the first reception (20) at the front face side.

7. Arrangement according to at least one of the preceding claims,
**characterized in**
**that** from the sidewall (24), disposed in the proximity of the front face (18) of the basic element (12), of the first groove (20) extending in the side margin region (14) a projection (22) extends, that the first leg (42), U-form in section, of the spring element (14) extends with its free end (64) between the projection and the groove bottom (28); and that the further leg of the spring element is a second U-form leg (48) which comprises a peripheral segment (54) bent in the direction of the first U-form leg.

8. Arrangement according to at least one of the preceding claims,
**characterized in**
**that** the first peripheral region (54), bent in the direction of the fist U-form leg (42) of the second U-form leg (48) extends with its free edge (60) within the space (62) encompassed by the first U-form leg.

9. Arrangement according to at least one of the preceding claims,
**characterized in**
**that** the first and the second U-form leg (42, 48) form an acute angle with respect to their inner leg segments (46, 50) of which one changes over into the other.

10. Arrangement according to at least one of the preceding claims,
**characterized in**
**that** the inner leg segments (46, 50),of which one changes over into the other, of the fist and second U-form leg (42, 48) form an angle of approximately 50° to 70°, preferably approximately 60°.

11. Arrangement according to at least one of the preceding claims,
**characterized in**
**that** the length of the first U-form leg (42) is less than that of the second U-form leg (48), with the ration of the lengths of the legs being approximately 1:1.4 to 1:3.0, in particular approximately 1:2.

12. Arrangement according to at least one of the preceding claims,
**characterized in**
**that** the peripheral region (54) of the outer leg segment (52) of the second U-form leg (48) is bent at a spacing from its apex region (56) in the direction of the first U-form leg (42), which is approximately equal to the spacing between the apex point and transition between the inner leg segments (46, 50) from the first and second U-form leg (42, 48).

13. Arrangement according to at least one of the preceding claims.
**characterized in**
**that** the apex region (56) of the second U-form leg (48) extends in a second receptor such as groove (30) of a wall leg (16), extending into the housing ,of the basic segment (12).

14. Arrangement according to at least one of the preceding claims,
**characterized in**
**that** the first and second groove (20, 30) or their center axes form an acute angle which corresponds approximately to the angle which is formed by the first and second U-form leg (42, 48) with its center axes.

15. Arrangement according to at least one of the preceding claims,
**characterized in**
**that** the sidewall (26), disposed remote from the front face (18), of the first groove (28) has a lesser depth than the sidewall (24) disposed in the proximity of the front face.

16. Arrangement according to at least one of the preceding claims,
**characterized in**
**that** the basic element (12, 94) is a sheet front panel or a portion of a profile front panel, preferably U- or L-form in section, or a segment of a sidewall closure profile.

## Revendications

1. Dispositif de blindage à haute fréquence, de parois ou de pièces d'un boîtier notamment d'une plaque frontale (10) d'un support d'ensemble, selon lequel les parois ou des parties de celles-ci comportent chacune un élément de base (12) en forme de plaque ayant une fonction de blindage avec le cas échéant des branches de paroi (16) partant de cet élément de base pour pénétrer dans le boîtier, et
dans au moins une zone du bord latéral (14) s'étendant perpendiculairement à la surface frontale (18) de l'élément de base, il est prévu un premier logement tel qu'une rainure (20) avec une paroi latérale proche de la surface frontale et une paroi latérale éloignée de la surface frontale (24, 26) ainsi qu'un fond tel qu'un fond de rainure (28) pour recevoir une première branche (42) à section en forme de U, d'un élément de ressort (80) s'étend avec une autre branche (48) par zones le long de la zone du bord latéral,
**caractérisé en ce que**
la première branche (42) à section en forme de U de l'élément de ressort (80) présente dans sa zone de bord transversale (84) avant, libre, au moins un segment (92, 94) situé dans ou essentiellement dans le plan sous-tendu par le segment de branche extérieur (82) en s'appuyant contre la paroi latérale (24) proche de la surface frontale (18) du premier logement (20), et
l'autre branche de l'élément de ressort est une seconde branche (48) en forme de U ayant un segment de bord (54) cintré en direction de la première branche en forme de U.

2. Dispositif selon la revendication 1,
**caractérisé en ce que**
la zone de bord transversale avant (84) présente un tracé en forme de V de préférence au moins une pointe (92, 94) formant une saillie dans le plan et constituant le segment.

3. Dispositif selon l'une au moins des revendications précédentes,
**caractérisé en ce que**
le segment de branche (82) extérieur de la première branche (42) en forme de U du bord longitudinal respectif (88, 90), présente un segment (86) en forme de toit, partant de la zone de bord transversale extérieure (84).

4. Dispositif selon au moins l'une des revendications précédentes,
**caractérisé en ce que**
pour la première branche en forme de U (42) introduite dans le premier logement tel que la rainure (20), son segment de branche extérieur (82) est dans un plan (96) qui coupe la paroi latérale (24) proche de la surface frontale suivant un angle (β) tel que de préférence 60°≥ β ≥ 20°, notamment 45° ≥ β ≥ 30°.

5. Dispositif selon au moins l'une des revendications précédentes,
**caractérisé en ce que**
lorsque l'élément de ressort (80) est détendu, le bord transversal extérieur libre (60) de la seconde branche (48) en forme de U se situe dans ou sensiblement dans un plan sous-tendu par la zone transitoire (58) entre la première et la seconde branches en forme de U et la zone de bord transversale (84) de la première branche (42) en forme de U.

6. Dispositif selon au moins l'une des revendications précédentes,
**caractérisé en ce que**
la zone de bord (54) de la seconde branche en forme de U (48), cintrée en direction de la première branche (42) en forme de U, vient avec son bord libre (60) au niveau de la projection verticale de la paroi latérale (24) délimitant du côté de la surface frontale le premier logement (20).

7. Dispositif au moins l'une des revendications précédentes,
**caractérisé en ce que**
la paroi latérale (24), proche de la surface frontale (18) de l'élément de base (12), de la première rainure (20) située dans la zone de bord latérale (14) comporte une partie en saillie (22),
la première branche (42) à section en U de l'élément de ressort (14) s'étend avec son extrémité libre (64) entre la partie en saillie et le fond de rainure (28) et
l'autre branche de l'élément à ressort est une seconde branche (48) en forme de U ayant un segment de bord (54) cintré en direction de la première branche en forme U.

8. Dispositif selon au moins l'une des revendications précédentes,
**caractérisé en ce que**
la zone de bord (54) de la seconde branche (48) en forme de U, recourbée en direction de la première branche (42) en forme de U, s'étend avec son bord libre (60) à l'intérieur de l'espace (62) entouré par la première branche en forme de U.

9. Dispositif selon au moins l'une des revendications précédentes,
**caractérisé en ce que**
la première et la seconde branches (42, 48) en forme de U forment entre elles un angle aigu par leurs segments de branche intérieurs (46, 50) qui se rejoignent.

10. Dispositif selon l'une des revendications précédentes,
**caractérisé en ce que**
les segments de branche intérieurs (46, 50) qui se rejoignent et appartenant à la première et à la seconde branches (42, 48) en forme de U font entre eux un angle de l'ordre de 50° à 70° et de préférence de l'ordre de 60°.

11. Dispositif selon l'une des revendications précédentes,
**caractérisé en ce que**
la longueur de la première branche (42) en forme de U est inférieure à celle de la seconde branche (48) en forme de U et les longueurs des branches sont sensiblement dans un rapport de 1/1,4 jusqu'à 1/3,0 et en particulier de l'ordre de 1/2.

12. Dispositif selon l'une des revendications précédentes,
**caractérisé en ce que**
la zone de bord (54) du segment de branche extérieur (52) de la seconde branche (48) en forme de U est cintrée à une distance de sa zone de sommet (56) en direction de la première branche (42) en forme de U, qui est sensiblement égale à la distance entre le sommet et la transition entre les segments de branche intérieurs (46, 50) et la première et la seconde branches (42, 48) en forme de U.

13. Dispositif selon l'une des revendications précédentes,
**caractérisé en ce que**
la zone de sommet (56) de la seconde branche (48) en forme de U vient dans un second logement tel qu'une rainure (30) d'une branche de paroi (16) du segment de base (12) qui s'étend dans le boîtier.

14. Dispositif selon l'une des revendications précédentes,
**caractérisé en ce que**
la première et la seconde rainures (20, 30), ou leurs axes médians, forment entre elles (eux) un angle aigu qui correspond sensiblement à l'angle qui formé par la première et la seconde branche en U (42, 48) avec son axe médian.

15. Dispositif selon l'une des revendications précédentes,
**caractérisé en ce que**
la paroi latérale (26) éloignée de la surface frontale (18) de la première rainure (28) présente une profondeur inférieure à celle de la paroi latérale (24) proche de la surface frontale.

16. Dispositif selon l'une des revendications précédentes,
**caractérisé en ce que**
l'élément de base (12, 94) est une plaque frontale en tôle, ou une partiel d'une plaque frontale profilée ayant une section en U ou en L, ou un segment du profil d'extrémité de paroi latérale de préférence.
